# EUROPÄISCHE PATENTANMELDUNG

(11) **EP 2 827 217 A1**
(43) Veröffentlichungstag der Anmeldung: **21.01.2015**
(21) Anmeldenummer: 14156803.0
(22) Anmeldetag: 26.02.2014
(51) Int. Cl.: G05F 1/56, H02H 9/04

(54) **Spannungsbegrenzer und Verwendung eines Spannungsbegrenzers zum Bestimmen von Werten eines Leistungshalbleiterelements**

(30) Priorität: 18.07.2013 DE 102013107699
(71) Anmelder: Springburo GmbH, 79312 Emmendingen (DE)
(72) Erfinder: Springett, Nigel, 79312 Emmendingen (DE)
(74) Vertreter: Hornig, Leonore

(57) **Zusammenfassung**

Die Erfindung betrifft einen Spannungsbegrenzer 1 mit einem unipolaren Haupttransistor 7, wobei der Haupttransistor 7 einen Drain-Anschluss 8 aufweist, der mit einem Eingang 2 des Spannungsbegrenzers 1 verbunden ist, einen Source-Anschluss 9, der mit einem Ausgang 3 des Spannungsbegrenzers 1 verbunden ist, und einen Gate-Anschluss 10. Der Spannungsbegrenzer 1 ist dadurch vielseitiger einsetzbar, dass der Gate-Anschluss 10 des Haupttransistors 1 mit einem vorherbestimmten Potential verbunden ist, das so gewählt ist, dass ein am Drain-Anschluss 8 anliegendes Eingangsspannungssignal am Source-Anschluss 9 auf einen vorgegebenen Maximalwert begrenzt wird.

## Beschreibung

Die Erfindung betrifft einen Spannungsbegrenzer für Leistungsbauelemente mit einem unipolaren Haupttransistor, wobei der Haupttransistor einen Drain-Anschluss aufweist, der mit einem Eingang des Spannungsbegrenzers verbunden ist, einen Source-Anschluss, der mit einem Ausgang des Spannungsbegrenzers verbunden ist, und einen Gate-Anschluss. Die Leistungsbauelemente sind in der Regel Halbleiterelemente.

Aus der US 2010/0164 448 A1 ist ein solcher Spannungsbegrenzer bekannt. Mit diesem Spannungsbegrenzer wird das Ausgangssignal einer Spannungsversorgungseinrichtung auf einen festen Spannungswert geregelt, um einen Schaden an einer variablen Last, die an den Ausgang angeschlossen werden kann, zu verhindern. Zwischen dem Eingang und dem Ausgang des Spannungsbegrenzers ist ein Gate-Element vorgesehen, welches mittels eines Vergleichsspannungssignals aktiviert wird. Das Vergleichsspannungssignal wird mittels einer Vergleichsschaltung erzeugt und zwar so, dass sich das Gate-Element bei einer normalen und schweren Last im Sättigungszustand, bei einer leichten Last im linearen Zustand befindet. Bei dieser Schaltung ist eine aktive Vergleichsschaltung erforderlich, welche das Gate-Element aktiv schaltet. Dies macht die Schaltung aufwändig. Zudem wird die Zeit, mit der das Gate-Element geschaltet werden kann, durch den Regelkreis, der zum Ansteuern des Gate-Elements erforderlich ist, bestimmt. Hierdurch ist die Schaltung relativ langsam. Es können daher am Ausgang grundsätzlich nur statische Zustände betrachte werden. Eine dynamische Messung der Übergänge des Eingangssignals am Ausgang des Spannungsbegrenzers ist beispielsweise nicht möglich.

Der Erfindung liegt die Aufgabe zugrunde, einen Spannungsbegrenzer mit einfachem Aufbau zu schaffen, mit dem zeitliche Übergänge eines Spannungssignals am Eingang des Spannungsbegrenzers, beispielsweise eines Schalters, an dessen Ausgang zuverlässig gemessen werden können und der breiter verwendbar und einsetzbar ist.

Diese Aufgabe wird durch einen gattungsgemäßen Spannungsbegrenzer gelöst, bei dem der Gate-Anschluss des Haupttransistors mit einem mit einem vorherbestimmten Potential verbunden ist, welches so gewählt ist, dass ein am Drain-Anschluss anliegendes Eingangsspannungssignal am Source-Anschluss auf einen vorgegebenen Maximalwert begrenzt wird. Zum Bereitstellen des vorherbestimmten Potentials kann eine Spannungsquelle verwendet werden, die ein vorherbestimmtes periodisches oder ein vorherbestimmtes konstantes Potential erzeigt.

Hierdurch wird ein sehr einfacher Aufbau der Vorrichtung erreicht. Es ist kein zusätzlicher Regelkreise noch ein Schaltelement zur Ansteuerung des Gate-Anschlusses des Haupttransistors erforderlich. Dadurch hat der Spannungsbegrenzer auch eine sehr große Zeitauflösung. Ein am Eingang des Spannungsbegrenzers anliegendes Spannungssignal wird auf den vorgegebene Maximalwert begrenzt, indem alle Werte unterhalb des Maximalwertes zum Ausgang des Spannungsbegrenzers durchgelassen werden und alle Werte oberhalb des Maximalwertes abgeschnitten werden. Aufgrund der hohen Zeitauflösung des Spannungsbegrenzers steht der untere Teil des Eingangsspannungssignals, der unterhalb des Maximalwertes liegt, am Ausgang des Spannungsbegrenzers mit einer hohen Zeitauflösung zur Verfügung. Dadurch kann beispielsweise der untere Teil des Eingangsspannungssignals mit hoher Zeitauflösung gemessen werden. Dies eröffnet viele Anwendungsmöglichkeiten des Spannungsbegrenzers, wie das Messen der Spannung von elektronischen Schaltern während ihres Betriebs, das Messen der Charakteristik der Durchlassspannung von Dioden während ihre Betriebs, das Messen der Spannung währen dem Einschalten oder Ausschalten von elektronischen Komponenten sowie das Bestimmen von Werten, die in Korrelation mit der Spannung stehen, wie z.B. Sperrschichttemperatur, Strom- und Temperaturverhalten von Leistungsbauelementen während ihres Betriebs.

Zum Bereitstellen des Bezugspotentials kann eine Gleichspannungsquelle oder eine Wechselspannungsquelle verwendet werden, deren einer Ausgang mit dem Gate-Anschluss des Haupttransistors und deren anderer Ausgang mit dem gemeinsamen Bezugspotential des Spannungsbegrenzers verbunden ist. Das für den Gate-Anschluss gewählte Potential wird abhängig von dem jeweiligen Transistor-Typ des Haupttransistors gewählt. Es kann sowohl ein Transistor vom Verarmungstyp, ein selbstleitender Transistor, als auch ein Transistor vom Anreicherungstyp, ein selbstsperrender Transistor, verwendet werden. Bei einem selbstsperrenden Transistor wird immer ein positives Potential für den Gate-Anschluss gewählt, bei einem selbstleitenden Transistor kann abhängig von den Transistoreigenschaften und dem gewünschten Maximalwert der Gate-Anschluss auch mit einem negativen Potential der Gleichspannungsquelle verbunden werden.

Als Haupttransistor wird ein unipolarer Transistor verwendet. Diese Transistoren haben vorteilhafte Eigenschaften für den Spannungsbegrenzer, wie gute Hochfrequenzeigenschaften und ein schnelles Schaltverhalten. Die maximale Ausgangsspannung entspricht der Gate-Spannung abzüglich der Gate-Source-Schwellspannung des Transistors. Bei der erfindungsgemäßen Verwendung als Haupttransistor ist die maximale Spannung des Spannungsbegrenzers durch die Gate-Source-Schwellspannung des Haupttransistors bestimmt.

Gemäß einem vorteilhaften Ausführungsbeispiel der Erfindung wird als vorherbestimmtes Potential ein zumindest periodisch konstantes vorherbestimmtes Potential verwendet. Ein zumindest periodisch konstantes vorherbestimmtes Potential kann sowohl ein konstantes Potential als auch ein periodisch wechselndes Signal mit konstanten Signalanteilen, welches im Wesentlichen einen rechteckigen Signalverlauf hat, sein. Hierdurch wird die maximale Ausgangsspannung ebenfalls auf einen zumindest periodisch konstanten Wert begrenzt.

Gemäß einem weiteren vorteilhaften Ausführungsbeispiel des erfindungsgemäßen Spannungsbegrenzers ist als Haupttransistor ein selbstleitender Transistor vorgesehen sein, dessen Drain-Anschluss mit dem Eingang, dessen Source-Anschluss mit dem Ausgang und dessen Gate-Anschluss mit einem gemeinsamen Bezugspotential verbunden ist. Dies hat den Vorteil, dass die Anordnung weiter vereinfacht, da keine externe Spannungsquelle erforderlich ist.

Der erfindungsgemäße Spannungsbegrenzer hat fernen den Vorteil, dass die Spannung eines an dem Eingang liegenden elektronischen Bauteils, beispielsweise eines elektronischen Schalters, mit hoher Genauigkeit gemessen werden kann. Ein elektronischer Schalter enthält typischerweise eine Diode, einen MOSFET, IGBT's, GaN-Transistoren oder ein ähnliches Bauteil. Diese haben normalerweise eine niedrige Spannung im leitfähige Zustand und eine hohe Spannung im Sperrzustand. Aufgrund der großen Dynamik in dem Spannungsbereich ist es mit herkömmlichen Methoden problematisch, die Spannung in dem leitenden Zustand zuverlässig zu messen.

Mittels des erfindungsgemäßen Spannungsbegrenzers wird die Spannung des Schalters am Ausgang des Spannungsbegrenzers auf einen vorgegebenen Maximalwert begrenzt. Der Maximalwert liegt vorteilhafterweise im Niederspannungsbereich, bei vielen Anwendungen in einem Bereich von etwa 1 Volt bis etwa 15 Volt. Dies kann durch die geeignet Wahl des Haupttransistors und des vorherbestimmten Potentials an dem Gate-Anschluss des Haupttransistors erreicht werden. Es wird ein Hochspannungstransistor verwendet, beispielsweise mit einer Grenzspannung von etwa 400 V und höher.

In dem Sperrzustand des Schalters wird die hohe Ausgangsspannung, welche beispielsweise zwischen 1000 V und 2000 V betragen kann, auf den Maximalwert begrenzt. Die niedrigere Spannung im leitenden Zustand des Haupttransistors sowie alle Spannungen während des Schaltzustandes, die kleiner als der Maximalwert sind, liegen am Ausgang des Spannungsbegrenzers unverändert an. Somit können diese Spannungen in einem kleineren Dynamikbereich und daher mit hoher Genauigkeit gemessen werden. Hierzu können übliche Messgeräte verwendet werden, beispielsweise ein Oszilloskop oder ein digitales Multimeter. Somit können die Ausgangsspannungen des leitenden Zustandes des Schalters und des Schaltübergangs mit einer hohen Auflösung gemessen werden. Typischerweise liegen die Spannungen im leitfähigen Zustand eines Schalters im Bereich von einigen 100 mV. Die Maximalspannung kann so gewählt werden, dass diese Spannungen mit einer gewünschten Auflösung messbar sind. Als Haupttransistor kann hierfür beispielsweise ein selbstleitender JFET-Transistor verwendet werden. Seine Schwellspannung wird so gewählt, dass er die Spannung am Ausgang auf den gewünschten Maximalwert begrenzt. Mit dem erfindungsgemäßen Spannungsbegrenzer kann generell ein im Hochspannungsbereich liegendes Spannungssignal, welches auf den Eingang gegeben wird, auf einen vorgegebenen Maximalwert im Niederspannungsbereich begrenzt werden. Die Werte des Eingangsspannungssignals, die unterhalb des Maximalwertes liegen, können somit am Ausgang des Spannungsbegrenzer mit hoher Genauigkeit gemessen, dargestellt, analysiert oder anders weiterverwendet werden.

Bei einer vorteilhaften Ausbildung der Erfindung weist der selbstleitende Haupttransistor eine Drain-Source-Kapazität von etwa 100pF, vorzugsweise 30pF oder weniger auf. Aufgrund der niedrigen Drain-Source-Kapazität werden vorteilhafte schnelle Reaktionszeiten des selbstleitenden Haupttransistors erreicht. Die Drain-Source-Kapazität ist spannungsabhängig und wird je nach den gewünschten Eigenschaften des Spannungsbegrenzers gewählt. Sie wird durch die Eigenschaften des Transistors bestimmt. Besonders geeignete Materialien sind Halbleitermaterialien mit einer großen Bandlücke, für einen solchen Transistor sind beispielsweise Siliziumcarbid, Galliumnitrid, Galliumarsenid.

Eine weitere Anwendung des Spannungsbegrenzers ist, dass aus der Ausgansspannung des Spannungsbegrenzers der Widerstand des Schalters bestimmt werden kann. Dieser kann beispielsweise von dem Messgerät, wie einem Oszilloskop, ausgerechnet werden, und der zeitliche Verlauf des Widerstandes kann bestimmt werden. Wegen der guten Zeitauflösung der Messungen kann auch das Widerstandsverhalten des Schalters während des Schaltprozesses gemessen werden.

Die oben erwähnte Verwendung des Spannungsbegrenzers zum Messen der Spannung eines elektronischen Schalters ist ein Anwendungsbeispiel und stellt keine Einschränkung dar. Der erfindungsgemäße Spannungsbegrenzer ist geeignet, um bei elektronischen Leistungsgeräten aller Art während des Betriebs die Spannung zu messen und alle deren Eigenschaften zu bestimmen, die von der Spannung im Betriebszustand abhängig sind, also in Korrelation zu den Spannungswerten stehen. Es kann beispielsweise aufgrund der Widerstandskurve der Verlust in den Bauteilen bestimmt werden. Es kann auch die Temperatur im Bereich der Sperrschicht eines Transistors bestimmt werden. Beispielsweise ist die Temperatur in der Sperrschicht eines MOSFET-Transistors etwa linear zu dem Widerstand, so dass sie sich aus der Widerstandskurve abschätzen lässt. Dies ist immer möglich, wenn die Kennlinie des Bauelements in Abhängigkeit von der Temperatur bekannt ist. Somit kann die Temperatur elektronische Bauteile mit einer Sperrschicht während des Fertigungsprozesses innerhalb der Sperrschicht bestimmt werden.

Eine weitere vorteilhafte Verwendung des erfindungsgemäßen Spannungsbegrenzers betrifft das Messen von Dioden. PN-Dioden weisen eine lange Einschaltzeit auf, die zu einem anfänglichen Spannungsanstieg führt, und einer darauffolgenden Abnahme der Spannung in Abhängigkeit von der Zeit. Dieses Verhalten kann mit dem erfindungsgemäßen Spannungsbegrenzer sehr genau gemessen werden, so dass die Einschaltzeit der Diode sowie die Leitspannung über der Diode genau bestimmt werden können.

Gemäß einer vorteilhaften Weiterbildung der Erfindung ist zwischen dem Gate-Anschluss des Haupttransistors und dem konstanten Potential ein erster Schutzwiderstand vorgesehen. Der erste Schutzwiderstand schützt die Gate-Elektrode des Haupttransistors bei Anliegen einer negativen Spannung am Drain-Anschluss. Der Schutzwiderstand ist so gewählt, dass der Strom durch die interne Diode zwischen Drain und Source beim Anliegen von negativen Spannungen am Eingang geeignet begrenzt wird. Somit sind auch negative Eingangsspannungen messbar. Auch ist es günstig, wenn ein Kondensator-Element parallel zu dem ersten Schutzwiderstand angeordnet ist. Hierdurch können die Hochfrequenzeigenschaften des Spannungsbegrenzers verbessert werden. Insbesondere kann so eine schnelle Schalt- und Reaktionszeit der Schaltung erreicht werden.

Ferner ist es vorteilhaft, wenn ein Überspannungsschutzelement zwischen den Source-Anschluss des selbstleitenden Haupttransistors und das gemeinsame Bezugspotential geschaltet ist. Hierfür kann beispielsweise eine bidirektionale Diode verwendet werden. Das Überspannungsschutzelement schützt ein am Ausgang angeschlossenes Messgerät z.B. im Fall eines Defektes des selbstleitenden Haupttransistors.

Vorteilhafterweise kann ein unipolarer Nebentransistor zwischen dem Haupttransistor und dem Ausgang des Spannungsbegrenzers angeordnet sein. Durch diesen kann die maximale Ausgangsspannung des Spannungsbegrenzers zusätzlich begrenzt werden; er kann auch dazu benutzt werden, das Ausgangssignal zu glätten und die Hochfrequenzeigenschaften zu verbessern. Es kann so eine noch höhere Auflösung bei einer Spannungsmessung erreicht werden. Zwischen den Gate-Anschluss und das gemeinsame Bezugspotential kann ein zweiter Schutzwiderstand und parallel zu diesem ein zweites Kondensator-Element geschaltet sein. Hierdurch kann die Genauigkeit der Messung der Ausgansspannung weiter verbessert werden. Als Nebentransistor kann vorteilhafterweise ein Niederspannungstransistor, typischerweise mit einer Grenzspannung von etwa 40 V verwendet werden. Die maximale Ausgangsspannung des Spannungsbegrenzers wird hier durch die Gate-Source-Spannung des Nebentransistors begrenzt.

Es ist auch günstig, wenn ein "matched-pair"-Transistorpaar vom gleichen Leitungstyp wie der Haupttransistor zwischen dem Haupttransistor und dem Ausgang angeordnet ist. Dieses Transtorpaar ist zur Kompensation der Offset-Spannung des Haupttransistors zwischen dem Gate-Anschluss und dem Source-Anschluss des Haupttransistors geeignet angeordnet. Das "matched-pair"-Transistorpaar ist so angeordnet, dass die Offsetspannungen der beiden das Transistorpaar bildenden Transistoren sich gegenseitig kompensieren. Hierdurch kann die maximale Ausgangsspannung des Spannungsbegrenzers genauer eingestellt werden.

Vorteilhafterweise ist ein Spannungsbegrenzendes Element zwischen den Gate-Anschluss des Haupttransistors und das gemeinsame Bezugspotential geschaltet. Es ist günstig, wenn das Spannungsbegrenzende Element hinter den Schutzwiderstand geschaltet ist. Hierdurch wird die maximale Spannung des Gate-Anschlusses des Haupttransistors begrenzt, wodurch die genaue Begrenzung der Ausgangsspannung des Spannungsbegrenzers sichergestellt wird. Es kann hierzu eine Zenerdiode in Reihe mit einer Diode verwendet werden. Bei diesem Ausführungsbeispiel der Erfindung wird die maximale Ausgangsspannung des Spannungsbegrenzers durch die maximale Spannung der Zenerdiode und durch die Flussspannung der Diode begrenzt, da die Gate-Spannung des Haupttransistors von der Zenerdiode und der Diode gesteuert wird. Der Gate-Anschluss des "matched-pair"-Transistorpaares ist vorteilhafterweise zwischen den Gate-Anschluss und das Spannungsbegrenzende Element geschaltet. Zwischen dem Gate-Anschluss des Haupttransistors und dem Spannungsbegrenzenden Element kann ein Schutzwiderstand angeordnet sein. Aufgrund dieser Anordnung kann für die Ausgangsspannung des Spannungsbegrenzers ein sehr genauer Wert erzielt werden. Bei diesem Ausführungsbeispiel der Erfindung kann gleichzeitig eine konstante Ausgangsspannung sowie eine schnelle Reaktionszeit der Schaltung erreicht werden.

Gemäß einem vorteilhaften Ausführungsbeispiel der Erfindung ist ein Leistungstransistor vorgesehen, dessen Drain-Anschluss mit dem Eingang des Spannungsbegrenzers verbunden ist, dessen Source-Anschluss mit einem gemeinsamem Bezugspotential verbunden ist und dessen Gate-Anschluss mit einem zumindest periodisch konstanten Potential verbunden ist. So kann der Haupttransistor zum Messen des Leistungstransistors verwendet werden; insbesondere können in dieser Anordnung Werte bestimmt werden, die in Korrelation mit Spannungswerten des Leistungstransistors stehen, welche auch die Spannungswerte selbst einschließen. Diese Werte können insbesondere im Niederspannungsbereich sehr genau bestimmt werden. Der Gate-Anschluss des Leistungstransistors kann entweder mit einer Gleichspannungsquelle verbunden sein, die mit einem gemeinsamen Bezugspotential verbunden ist, oder mit einem gemeinsamen Bezugspotential verbunden sein oder mit einer Spannungsquelle, die ein periodisch konstantes Signal, wie ein Rechtecksignal, erzeugt. Auch kann der Gate-Anschluss des Leistungstransistors mit dem Gate-Anschluss des Haupttransistors verbunden sein. Dies ist insbesondere dann vorteilhaft, wenn der Leistungstransistor und der Haupttransistor Transistoren gleichen Typs sind. Die Anordnung kann hierdurch vereinfacht werden. Mit dem Haupttranstor kann gemäß diesen Ausführungsbeispielen die Spannung des Leistungstransistors zuverlässig gemessen werden, während dieser in Betrieb ist. Damit kann der Leistungstransistor während des Betriebs kontinuierlich geprüft werden.

Ferner ist es vorteilhaft, wenn der Haupttransistor als ein Zell-Transistor des Leistungstransistors ausgebildet ist. Dies ist insbesondere vorteilhaft, wenn der Leistungstransistor bereits aus einer Anzahl von Zell-Transistoren ausgebildet ist, was bei Leistungstransistoren in der Regel der Fall ist. Dann bildet der Haupttransistor einen Teil des Leistungstransistors und ist in diesen integriert. Entsprechend kann ein Messtransistor parallel zu dem Nebentransistor oder als integrierter Zell-Transistor des Nebentransistors ausgebildet werden. Als Leistungstransistor wird vorteilhafterweise ein HEMT- oder JFET-Transistor verwendet. Als Haupttransistor ist es vorteilhaft, wenn ebenfalls ein HEMT- oder JFET-Transistor gleichen Leitungstyps verwendet wird.

Vorteilhafterweise kann ein Niederspannungs-Transistor vorgesehen sein, der mit dem Leistungstransistor eine KaskodenSchaltung bildet. Der Drain-Anschluss des Niederspannungs-Transistors ist mit dem Source-Anschluss des Leistungstransistors verbunden, die Gate-Anschlüsse des Leistungstransistors und des Haupttransistors sind mit dem gemeinsamen Bezugspotential oder dem konstanten Potential verbunden. Wenn ein Steuersignal an den Gate-Anschluss des Niederspannungs-Transistors angelegt wird, fließt ein Strom von dem Drain-Anschluss zu dem gemeinsamen Bezugspotential bzw. dem konstanten Potential. Ist der Niederspannungs-Transistor eingeschaltet, leitet der Leistungstransistor; ist der Niederspannungs-Transistor ausgeschaltet, sperrt der Leistungstransistor. Der Spannungsbegrenzer misst so die gesamte Spannung über dem Niederspannungs-Transistor und dem Leistungstransistor. Gemäß einem vorteilhaften Ausführungsbeispiel wird als Niederspannungs-Transistor ein MOSFET, insbesondere ein n-Kanal-Transistor verwendet und als Leistungstransistor ein JFET-Transistor vom Typ der Ladungsträgerverarmung oder ein Transistor ähnlicher Art.

Gemäß einer günstigen Ausführung der Erfindung ist das Bezugspotential des Ausgangs des Spannungsbegrenzers von dem Bezugspotential des Eingangs des Spannungsbegrenzers getrennt. Die Ausgänge werden somit von dem Eingangsbereich der Spannungsbegrenzerschaltung zuverlässig elektrisch isoliert, so dass keine elektrisch leitfähige Verbindung zwischen den Ausgängen und dem Eingangsbereich der Spannungsbegrenzerschaltung besteht. Dies ist besonders dann vorteilhaft, wenn der Eingangsbereich als Hochspannungsteil der Spannungsbegrenzerschaltung ausgebildet ist; denn in diesem Fall wird eine Potentialtrennung der Eingangsspannung im Hochspannungsbereich von der Ausgangsspannung oder Messspannung im Niederspannungsbereich erreicht. Dies kann beispielsweise durch eine galvanische Trennung des Ausgangs von dem Eingangsbereich erreicht werden. Als Isolations-Mittel zum Galvanischen Trennen kann beispielsweise ein Optokoppler verwendet werden, der linear zwischen Operationsverstärker geschaltet ist. Es können auch Isolations-Transformatoren verwendet werden, die zwischen einen Analog-Digital-Wandler und einen Digital-Analog-Wandler geschaltet sind, wobei ein Operationsverstärker zwischen den Digital-Analog-Wandler und dem Ausgang zur Impedanz-Anpassung geschaltet ist. Alternativ kann ein Differenzverstärker mit Verstärkungsfaktor 1 zwischen den Ausgang vor den Ausgang des Spannungsbegrenzers geschaltet werden. Gemäß einem vorteilhaften Ausführungsbeispiel des Spannungsbegrenzers ist der Source-Anschluss des Haupttransistors mit einer Stromquelle verbunden, deren Strom proportional zu der Spannung zwischen dem Source-Anschluss des Haupttransistors und dem gemeinsamen Bezugspotential ist, und welche in Reihe mit einem Ausgangswiderstand geschaltet ist, wobei die Ausgangsspannung des Spannungsverstärkers an wenigstens einem Teil des Ausgangswiderstands abgreifbar ist. Hierbei erfolgt die Trennung des Bezugspotentials des Ausgangs von dem Bezugspotential des Eingangs des Spannungsbegrenzers auf sehr einfache Weise. Die Ausgangsspannung kann an dem Ausgangswiderstand oder an einem Teil des Ausgangswidersands abgegriffen werden. Auch kann ein weiterer Widerstand in Reihe zu dem Ausgangswiderstand geschaltet werden. Es kann je nach Anwendungsfall eine intern versorgte Stromquelle vorgesehen werden, bei welcher der Strom von dem Ausgang des Haupttransistors kommt, oder eine von einer extern gespeisten Stromquelle, bei welcher der Strom von einer externen Versorgungseinheit kommt.

Nach einem anderen Ausführungsbeispiel des erfindungsgemäßen Spannungsbegrenzer ist ein zweiter Haupttransistor vorgesehen, welcher einen Drain-Anschluss aufweist, der mit einem zweiten Eingang des Spannungsbegrenzers verbunden ist, einen Source-Anschluss, der mit einem zweiten Ausgang des Spannungsbegrenzers verbunden ist, und einen Gate-Anschluss, der mit dem vorherbestimmten konstanten Potential verbunden ist. Dadurch können mit dem Spannungsbegrenzer zwei Leistungsbauelemente gleichzeitig gemessen, überprüft oder gesteuert werden. Entsprechend können weitere Haupttransistoren vorgesehen und verschaltet werden, und entsprechend weitere Leistungsbauelemente gemessen werden. Beispielsweise kann der Spannungsbegrenzer beim Überwachen des Betriebs und des Zustandes eines Motor-Treibers, wie eines Mehr-Phasen-Motor-Inverters, sowie zum Messen von dessen Strom verwendet werden, oder zum Überwachen und Steuern eines Schaltnetzteils.

In vorteilhafter Weis kann der erfindungsgemäße Spannungsbegrenzer zum Bestimmen von allen Werten verwendet werden, die in Korrelation stehen mit Spannungswerten im Niederspannungsbereich eines Leistungshalbleiterelements, wobei ein Spannungssignal des Leistungshalbleiterelements dem Eingang des Spannungsbegrenzers als Eingangssignal zugeführt wird, das auf den vorgegebenen Maximalwert begrenzte Signal am Ausgang des Spannungsbegrenzers als Ausgangsspannungssignal abgegriffen und derart verarbeitet wird, dass in Korrelation mit den abgegriffenen Spannungswerten stehende Werte bestimmt und/oder dargestellt werden. Beispiele wurden weiter oben bereits angeführt, die Spannungswerte selbst sind darin beinhaltet. Zudem kann das am Ausgang des erfindungsgemäßen Spannungsbegrenzers abgegriffene Spannungssignal zum Regeln einer Energieversorgungseinheit einer elektrischen Vorrichtung, insbesondere eines Motors oder eines Schaltnetzteils, verwendet werden.

Gemäß einer weiteren vorteilhaften Verwendung des Spannungsbegrenzers wird das am Ausgang des Spannungsbegrenzers abgegriffene Spannungssignal zum Überwachen des Betriebs eines Leistungstransistors verwendet. Dabei ist es weiterhin günstig, wenn ein Leistungstransistor mit einer Sperrspannung, die größer als 400 V beträgt verwendet wird.

Weitere Einzelheiten, Merkmale und Vorteile der vorliegenden Erfindung ergeben sich aus der nachfolgenden Beschreibung bevorzugter Ausführungsbeispiele unter Bezugnahme auf die Zeichnung.

Es zeigen:
Fig. 1 Eine schematische Darstellung eines Messaufbaus mit dem erfindungsgemäßen Spannungsbegrenzer,
Fig. 2 eine schematische Darstellung eines ersten Ausführungsbeispiels des erfindungsgemäßen Spannungsbegrenzers mit einem selbstleitenden Haupttransistor,
Fig. 3 eine schematische Darstellung eines weiteren Ausführungsbeispiels des erfindungsgemäßen Spannungsbegrenzers mit einem selbstleitenden Haupttransistor;
Fig. 4 eine schematische Darstellung eines weiteren Ausführungsbeispiels des erfindungsgemäßen Spannungsbegrenzers mit einem selbstleitenden Haupttransistor;
Fig. 5 ein Ausführungsbeispiel des erfindungsgemäßen Spannungsbegrenzers zum Messen eines Leistungstransistors,
Fig. 6, Fig. 7a und Fig.7b weitere Ausführungsbeispiel des erfindungsgemäßen Spannungsbegrenzers zum Messen eines Leistungstransistors,
Fig. 8 ein weiteres Ausführungsbeispiel des erfindungsgemäßen Spannungsbegrenzers,
Fig. 9 ein weiteres Ausführungsbeispiel des erfindungsgemäßen Spannungsbegrenzers,
Fig. 10 ein Ausführungsbeispiel des erfindungsgemäßen Spannungsbegrenzers mit mehreren Haupttransistoren,
Fig. 11 eine erfindungsgemäße Verwendung des Ausführungsbeispiels des erfindungsgemäßen Spannungsbegrenzers aus Figur 9,
Fig. 12 eine weitere Verwendung des erfindungsgemäßen Spannungsbegrenzers aus Figur 9,
Fig. 13 ein weiteres Anwendungsbeispiel der Verwendung des erfindungsgemäßen Spannungsbegrenzers und
Fig. 14 eine weitere Verwendung des erfindungsgemäßen Spannungsbegrenzers.

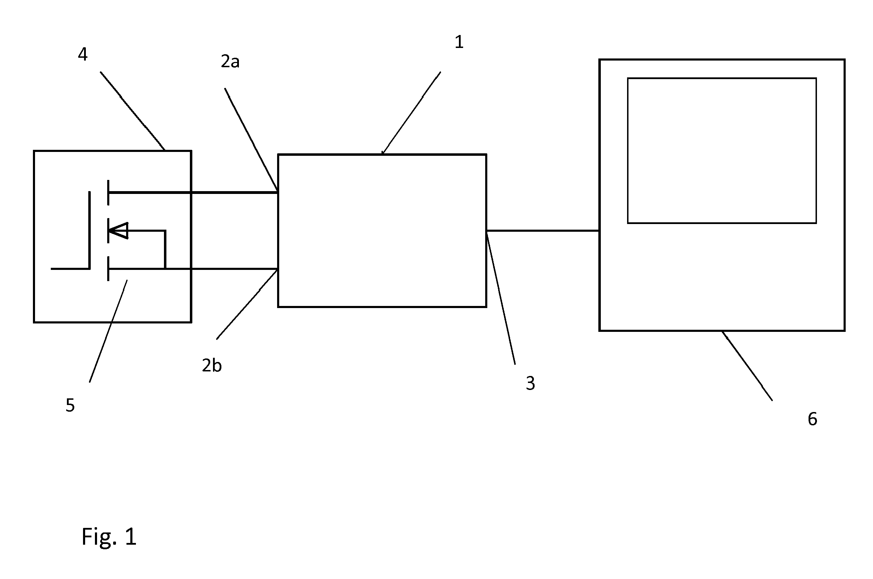

Figur 1 zeigt einen Spannungsbegrenzer 1 mit Eingängen 2a, 2b und mit einem Ausgang 3. An den Eingängen 2a, 2b ist ein elektronischer Schalter 4 angeschlossen, der einen SchaltTransistor 5 enthält. An den Ausgang 3 des Spannungsbegrenzers 1 ist ein Messgerät 6 angeschlossen, welches hier als Oszilloskop dargestellt ist. Mit dem Spannungsbegrenzer 1 wird die Ausgansspannung des Schalters 4 auf einen vorgegebenen Maximalwert begrenzt. Alle Werte der Ausgangsspannung des Schalters 4 unterhalb des Maximalwertes liegen an dem Ausgang 3 des Spannungsbegrenzers an und können mit dem Messgerät 6 gemessen und dargestellt werden. Der Maximalwert der Ausgangsspannung des Schalters 4 wird so gewählt, dass die Spannungswerte am Ausgang des Spannungsbegrenzers 1 in einem Bereich liegen, der mit Hilfe des Messgeräts 6 mit einer gewünschten Auflösung messbar ist. Da die Spannung eines Transistors, wie er für den Schalter 6 verwendet wird, beispielsweise eines MOSFET-Transistors, in Sperrzustand sehr viel größer ist als im leitfähigen Zustand, wird durch das Abschneiden der hohen Spannungen im Sperrzustand ermöglicht, dass die Spannungen im Schaltübergang und im leitfähigen Zustand des Schalters sehr gut und mit einer hohen Auflösung messbar sind.

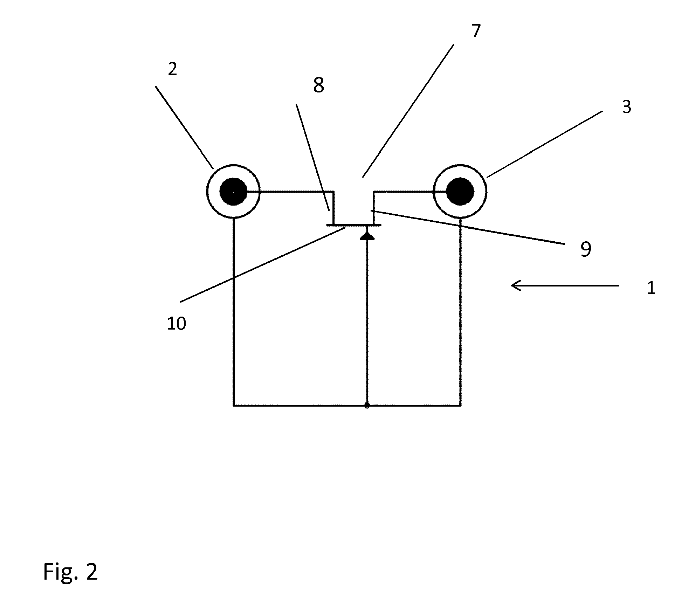

In Figur 2 ist eine Grund-Schaltung des Spannungsbegrenzers 1 gezeigt. Der Spannungsbegrenzer umfasst einen selbstleitenden Haupttransistor 7 mit einem Drain-Anschluss 8, einem Source-Anschluss 9 und einem Gate-Anschluss 10. Der Drain-Anschluss 8 ist mit dem Eingang 2 verbunden, der Source-Anschluss 9 mit dem Ausgang 3 und der Gate-Anschluss mit einem gemeinsamen Bezugspotential der Schaltung, welches beispielsweise die Masse sein kann. Aufgrund dieser Schaltung des selbstleitenden Haupttransistors wird erreicht, dass am Eingang 2 liegende Spannungen bis zu einem vorgegebenen Maximalwert an dem Ausgang 3 messbar sind. Am Eingang liegende Spannungen über dem Maximalwert sind am Ausgang den Maximalwert reduziert. Es wird ein selbstleitender Haupttransistor verwendet, der einen für die jeweilige Anwendung geeigneten Maximalwert aufweist. Besonders geeignet sind JFET-, HEMT- oder MISFET-Transistoren. Gute Eigenschaften werden erzielt, wenn der selbstleitende Haupttransistor eine Drain-Source-Kapazität von etwa 30pF oder weniger aufweist. Diese Schaltung des selbstleitenden Haupttransistors 7 hat zudem eine schnelle Responsezeit, so dass dynamische Prozesse gemessen werden können.

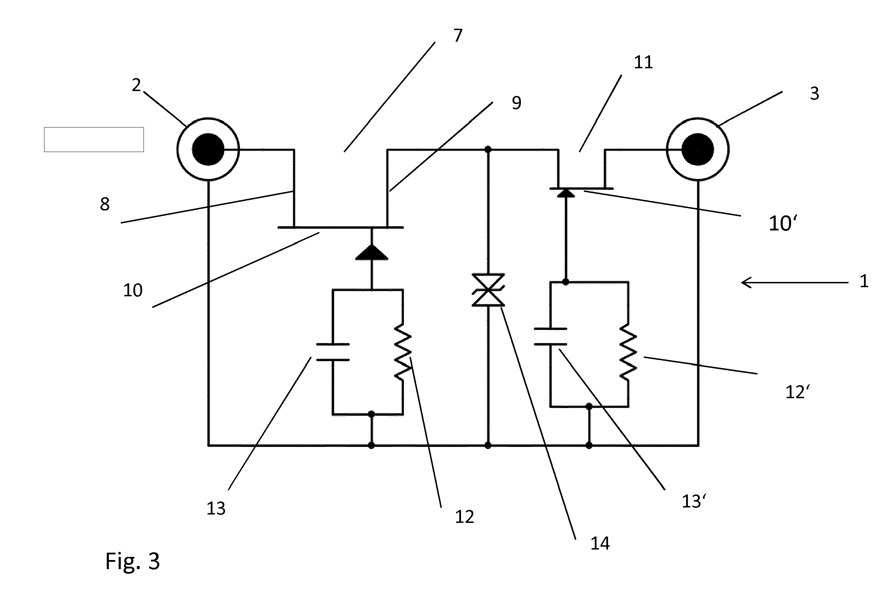

In Figur 3 ist ein weiteres Ausführungsbeispiel des Spannungsbegrenzers 1 dargestellt. Zu dem selbstleitenden Haupttransistor 7 ist ein selbstleitender Nebentransistor 11 in Reihe geschaltet. Aufgrund des Nebentransistors 11 kann der Maximalwert des Spannungsbegrenzers 1 weiter reduziert werden. Hierdurch kann eine höhere Auflösung in der Spannungsmessung des leitenden Zustandes des Schalters 4 erreicht werden. Es ist auch möglich weitere selbstleitende Transistoren entsprechend in Reihe zu schalten, wenn für eine spezielle Anwendung der Maximalwert der Ausgangsspannung des Spannungsbegrenzers niedriger gewählt werden soll.

Zwischen dem Gate-Anschluss 10 des Haupttransistors und dem gemeinsamen Bezugspotential ist ein erster Schutzwiderstand 12 und parallel zu diesem ein Kondensator-Element 13 geschaltet. Hierdurch wird es möglich, dass negative Spannungen am Eingang 2 des Spannungsbegrenzers 1 am Ausgang 3 gemessen werden können.

Entsprechend ist zwischen dem Gate-Anschluss 10' des Nebentransistors 11 und dem gemeinsamen Bezugspotential ein zweiter Schutzwiderstand 12' und parallel zu diesem ein zweites Kondensator-Element 13' geschaltet. Zwischen dem Source-Anschluss 9 des Haupttransistors 7 und dem gemeinsamen Bezugspotential ist ein Überspannungsschutzelement 14 angeordnet, durch welches verhindert wird, das bei einem Defekt des Haupttransistors 7 am Ausgang 3 des Spannungsbegrenzers 1 eine zu hohe Spannung anliegt. Als Überspannungsschutzelement 14 kann beispielsweise eine bidirektionale Spannungsbegrenzungs-Diode verwendet werden.

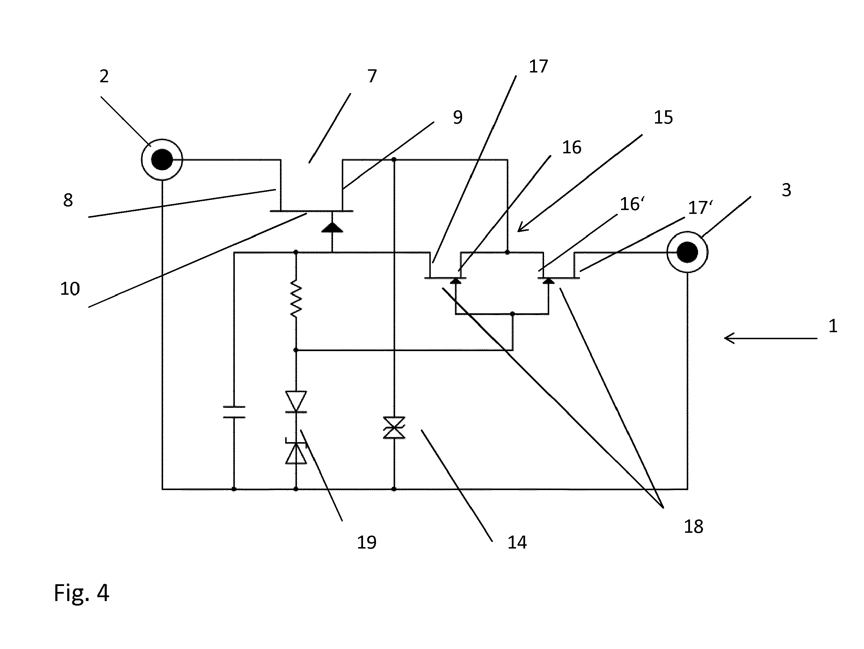

In dem Ausführungsbeispiel der Figur 4 ist zwischen dem selbstleitenden Haupttransistor 7 und dem Ausgang 3 des Spannungsbegrenzers 1 ein Transistorpaar 15 angeordnet. Das Transistorpaar 15 umfasst zwei aufeinander abgestimmte Transistoren ("matched pair"), bei denen es sich ebenfalls um selbstleitende Transistoren handelt, und deren Gate-Anschlüsse 18 miteinander verbunden sind. Die Drain-Anschlüsse 16, 16' der beiden Transistoren sind ebenfalls miteinander verbunden. Der Source-Anschluss 17 des einen Transistors des Transistorpaares 15 ist mit dem Gate-Anschluss 10 des Haupttransistors 7 verbunden, der Source-Anschluss 17' des zweiten Transistors des Transistorpaares 15 ist mit dem Ausgang 3 verbunden. Der Source-Anschluss 9 des Haupttransistors 7 ist mit den Drain-Anschlüssen 16, 16' der beiden Transistoren des Transistorpaares 15 verbunden. Zwischen die Gate-Anschlüsse 18 der beiden Transistoren des Transistorpaares 15 und das gemeinsame Bezugspotential ist ein Spannungsbegrenzendes Element 19 geschaltet, welches eine Zener-Diode und eine Diode in Reihe umfasst.

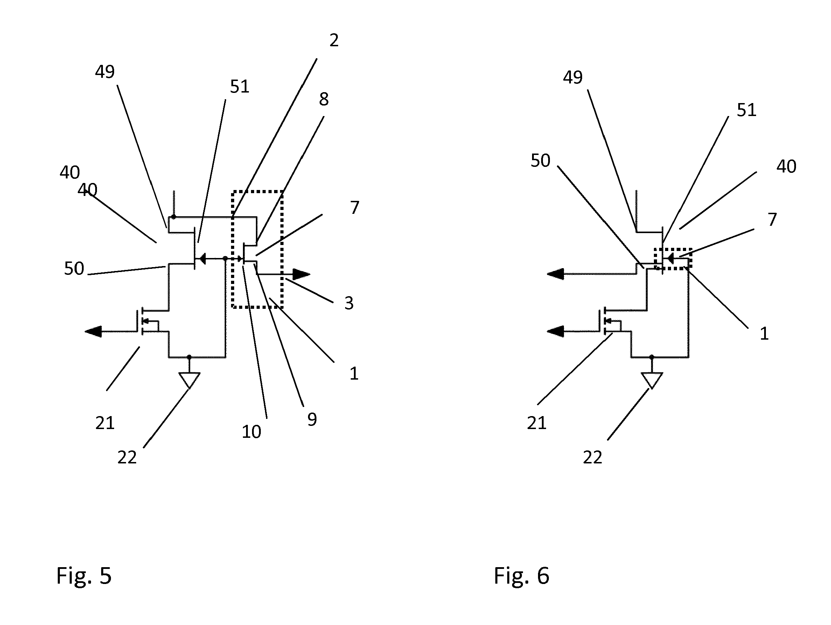

In Figur 5 ist eine Verwendung des erfindungsgemäßen Spannungsbegrenzers 1 zum Messen eines Leistungstransistors 40 gezeigt. Der Drain-Anschluss 49 des Leistungstransistors 40 ist mit dem Eingang 2 des Spannungsbegrenzers 1 und damit mit dem Drain-Anschluss 8 des Haupttransistors 7 verbunden. Der Source-Anschluss 50 des Leistungstransistors 40 ist über einen Niederspannungs-Transistor 21 mit einem gemeinsamen Bezugspotential verbunden, der Gate-Anschluss 51 des Leistungstransistors 40 mit dem Gate-Anschluss 10 des Haupttransistors 1. Der Niederspannungs-Transistor 21 und der Leistungstransistor 40 sind in Reihe geschaltet und bilden eine Kaskodenschaltung. Der Drain-Anschluss des Niederspannungs-Transistors 21 ist mit dem Source-Anschluss des Leistungstransistors 40 verbunden, die Gate-Anschlüsse des Leistungstransistors 40 und des Haupttransistors 7 sind mit dem gemeinsamen Bezugspotential Potential verbunden. Bei dem Haupttransistor 7 handelt es sich hier um einen selbstleitenden Transistor. Wenn ein Steuersignal an den Gate-Anschluss des Niederspannungs-Transistors 21 angelegt wird, fließt ein Strom von dem Drain-Anschluss zu dem gemeinsamen Bezugspotential bzw. dem konstanten Potential. Ist der Niederspannungs-Transistor eingeschaltet, leitet der Leistungstransistor; ist der Niederspannungs-Transistor ausgeschaltet, sperrt der Leistungstransistor. Der Spannungsbegrenzer 1 misst die gesamte Spannung über dem Niederspannungs-Transistor 21 und dem Leistungstransistor 40. Gemäß einem vorteilhaften Ausführungsbeispiel wird als Niederspannungs-Transistor ein n-Kanal-Transistor verwendet. Leistungstransistor, kann hier ein JFET-Transistor vom Typ der Ladungsträgerverarmung oder ein Transistor ähnlicher Art verwendet werden. Der Leistungstransistor 40 kann so während seines Betriebs gemessen bzw. überprüft werden. Mit dem Haupttransistor 7 kann so der Spannungsverlauf des Leistungstransistors 40 während seines Betriebs gemessen werden. Analog wie es oben beschrieben ist, können auch mittels des Haupttransistors 7 weitere Größen bestimmt werden, beispielsweise das Widerstandsverhalten des Leistungstransistors 40, dessen Temperatur- und Zeitverhalten oder andere Größen. Da der Niederspannungstransistor von niedrigen Spannungen, beispielsweise im Bereich von einigen 10 V angesteuert wird, kann das Schalten des Leistungstransistors 40, durch Ansteuerung im Niederspannungsbereich erfolgen.

In dem Ausführungsbeispiel des selbstleitenden Haupttransistors 7, der in der Figur 6 dargestellt ist, ist der Haupttransistor 7 in den Leistungstransistor 40 integriert. In dem gezeigten Ausführungsbeispiel handelt es sich bei dem Leistungstransistor 40 um einen selbstleitenden Transistor, der eine Vielzahl von zueinander parallel geschalteten Zell-Transistoren umfasst. Einer oder mehrere dieser Zell-Transistoren ist als Haupttransistor 7, der als Spannungsbegrenzer 1 geschaltet ist ausgebildet, und kann so als Messtransistor verwendet werden.

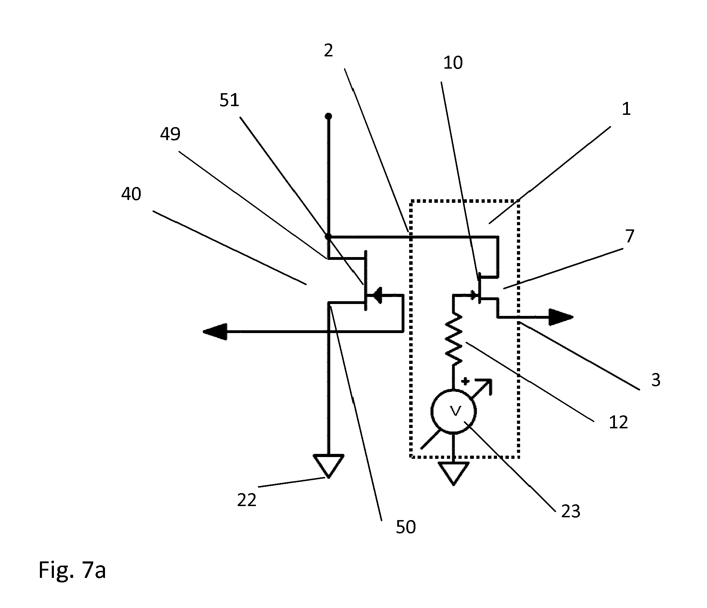

In Figur 7a ist die Verwendung des Spannungsbegrenzers 1 zum Messen der Spannung und weitere Eigenschaften des Leistungstransistors 40 gezeigt, bei dem als Haupttransistor 7 ein selbstsperrender oder selbstleitender Transistor verwendet werden kann. Der Gate-Anschluss 10 des Haupttransistors 7 ist mit dem Gate-Anschluss 51 des Leistungstransistors 40 verbunden und kann mit einem periodisch konstanten oder einem konstanten Potential beaufschlagt werden. Der Drain-Anschluss 49 des Leistungstransistors 40 ist mit dem Eingang 2 des Spannungsbegrenzers 1 verbunden. Der Source-Anschluss 50 des Leistungstransistors 40 ist mit einem gemeinsamen Bezugspotential verbunden ist. Der Source-Anschluss 9 des Haupttransistors 7 ist mit dem Ausgang 3 des Spannungsbegrenzers 1 verbunden. An dem Ausgang 3 kann ein Spannungssignal des Leistungstransistors 40 auf den vorgegebenen Maximalwert begrenzt abgegriffen werden. Aus diesem können Werte bestimmt werden, die mit den Spannungswerten des begrenzten Spannungssignals in Korrelation stehen.

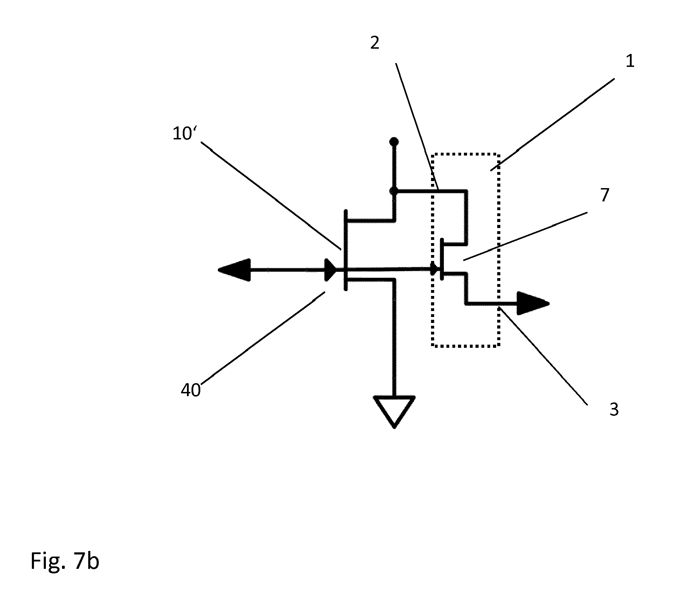

In dem Ausführungsbeispiel der Figur 7b wird der Gate-Anschluss 51 des Leistungstransistors 40 mit einem konstanten oder periodisch konstanten Potential beaufschlagt. Der Gate-Anschluss 10 des Haupttransistors 7 ist über den Schutzwiderstand 12 mit einer Gleisspannungsquelle 23 verbunden, welche wiederum mit dem gemeinsamen Bezugspotential 22 verbunden ist. Die sonstige Anordnung und Funktionsweise entspricht denen aus Fig. 7a. In der Anordnung aus Fig. 7b können unterschiedliche Transistor-Typen für den Leistungstransistor 40 und den Haupttransistor 7 verwendet werden.

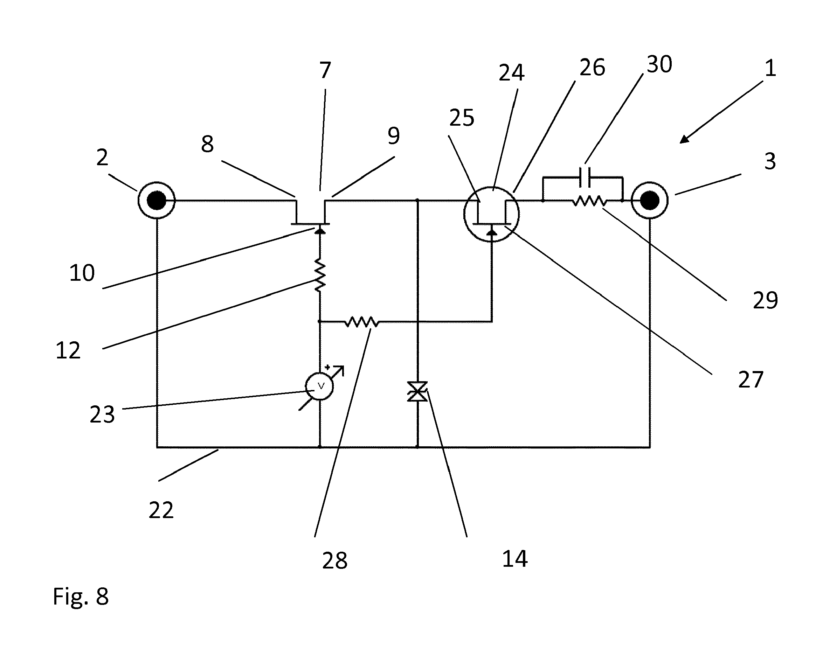

Figur 8 zeigt ein Ausführungsbeispiel des erfindungsgemäßen Spannungsbegrenzers 1, bei dem als Haupttransistor 7 sowohl ein selbstleitender als auch ein selbstsperrender Transistor verwendet werden kann. Der Gate-Anschluss 10 des Haupttransistors 7 ist über den Schutzwiderstand 12 mit einer Gleichspannungsquelle 23 verbunden, mit welcher der Gate-Anschluss 10 mit einem konstanten Potential beaufschlagt wird. Die Gleichspannungsquelle 23 ist mit dem gemeinsamen Bezugspotential 22 verbunden. Es ist ein Zusatztransistor 24 in Reihe mit dem Haupttransistor 7 geschaltet, dessen Drain-Anschluss 25 mit dem Source-Anschluss 9 des Haupttransistors 7, dessen Source-Anschluss 26 mit dem Ausgang 3 des Spannungsbegrenzers und dessen Gate-Anschluss 27 über einen zweiten Schutzwiderstand 28 mit der Gleichspannungsquelle 23 verbunden ist. Mit der Gleichspannungsquelle 23 werden die Gate-Anschlüsse 10, 27 des Haupttransistors 7 und des Zusatztransistors 24 so gesteuert, dass das Eingangssignal auf einen vorgegebenen Maximalwert reduziert wird. Mittels des Zusatztransistors 24 werden die Signaleigenschaften des durch den Haupttransistor reduzierten Signals verbessert. Mit der Spannungsquelle 23 können die Gate-Anschlüsse sowohl mit einem negativen als auch mit einem positiven Spannungssignal gesteuert werden. Daher kann ein gewünschter Maximalwert sowohl bei einem selbstleitenden als auch bei einem selbstsperrenden Transistor eingestellt werden.

Zwischen dem Source-Anschluss 26 des Zusatztransistors 24 und dem Ausgang 3 des Spannungsbegrenzers 1 ist ein Widerstandselement 29 mit einem parallelgeschaltetem kapazitivem Element 30 vorgesehen, welche eine Hochfrequenzkompensation am Ausgang 3 bei einer kapazitiven Last eines an den Ausgang 3 angeschlossenen Gerätes bewirken. Das zwischen den Source-anschluss 9 des Haupttransistors 7 und das gemeinsame Bezugspotential geschaltete Überspannungsschutzelement 14 dient zum Schutz eines am Ausgang angeschlossenen Messgeräts im Falle eines Defektes des selbstleitenden Haupttransistors 7.

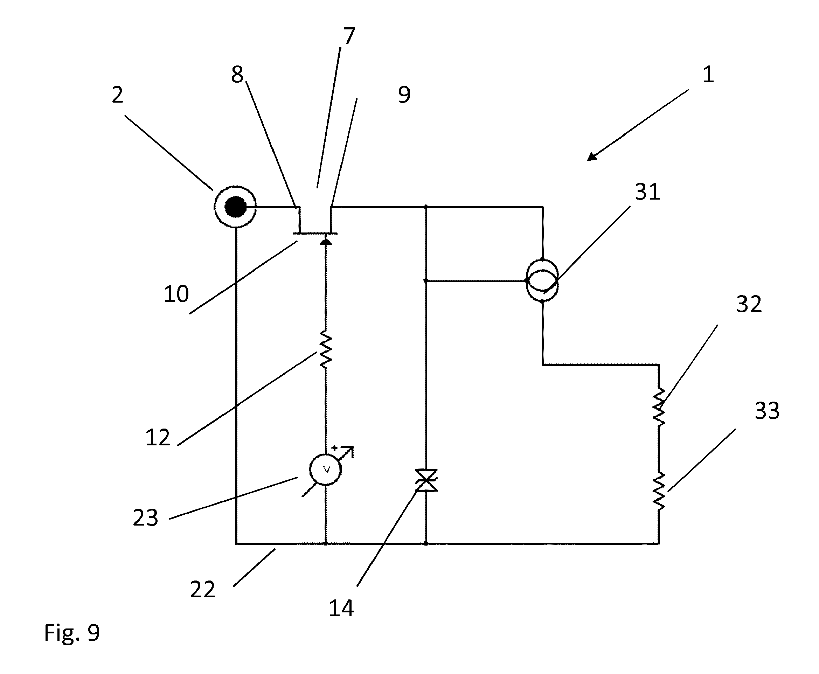

In dem Ausführungsbeispiel der Figur 9 ist der Gate-Anschluss 10 des Haupttransistors 7 ebenfalls mit dem Potential einer Gleichspannungsquelle 23 über einen Schutzwiderstand 12 verbunden. In diesem Ausführungsbeispiel ist zur Trennung des Bezugspotentials des Ausgangs des Spannungsbegrenzers 1 von dem Bezugspotential des Eingangs 2 des Spannungsbegrenzers 1 eine Stromquelle 31 vorgesehen, die derart angeordnet ist, dass ihr Strom proportional zu der Spannung zwischen dem Source-Anschluss des Haupttransistors und dem gemeinsamen Bezugspotential ist. Sie ist mit dem Source-Anschluss 9 des Haupttransistors 7 und in Reihe über die Ausgangswiderstände 32, 33 mit dem gemeinsamen Bezugspotential 22 verbunden. Zwischen die Stromquelle 31 und das gemeinsame Bezugspotential 22 sind ein erster und ein zweiter Ausgangswiderstand 32, 33 geschaltet. Typischerweise wird das Ausgangssignal an dem zweiten Ausgangswiderstand 33 abgegriffen. Hierdurch wird auf sehr einfache Weise eine Trennung des Bezugspotentials des Ausgangs des Spannungsbegrenzers 1 von dem Bezugspotential des Eingangs 2 des Spannungsbegrenzers 1 bewirkt.

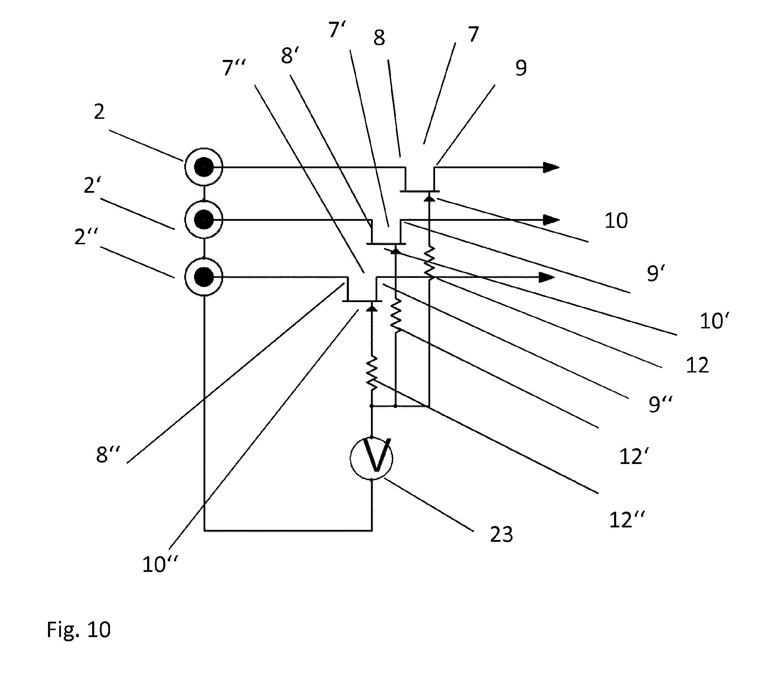

In Figur 10 ist ein Ausführungsbeispiel gezeigt, in dem 3 Haupttransistoren 7, 7', 7" zueinander parallel geschaltet sind. Jeder der Haupttransistoren 7, 7', 7" ist über seinen Drain-Anschluss 8, 8', 8" mit einem Eingang 2, 2', 2" des Spannungsbegrenzers 1 verbunden. Die Gate-Anschlüsse 10, 10', 10" der Haupttransistoren 7, 7', 7" sind jeweils über einen Schutzwiderstand 12, 12', 12" mit einer Gleisspannungsquelle 23 verbunden und werden derart mit einem Spannungspotential beaufschlagt, dass die Haupttransistoren 7, 7', 7" von einem an dem jeweiligen Drain-Anschluss 8, 8', 8" anliegenden Eingangsspannungssignal nur die Werte unterhalb eines vorgegebenen Maximalwertes durchlassen. Die so begrenzten Spannungssignale stehen an dem jeweiligen Ausgang des Spannungsbegrenzers 1 zur Verfügung. Es handelt sich hier um ein spezielles Ausführungsbespiel, das keine Einschränkung der Erfindung bedeutet. Es können auch weitere Haupttransistoren auf gleich Weise parallel geschaltet sein, oder andere Ausführungsbeispiele der Haupttransistoren und deren Beschaltung verwendet oder kombiniert werden.

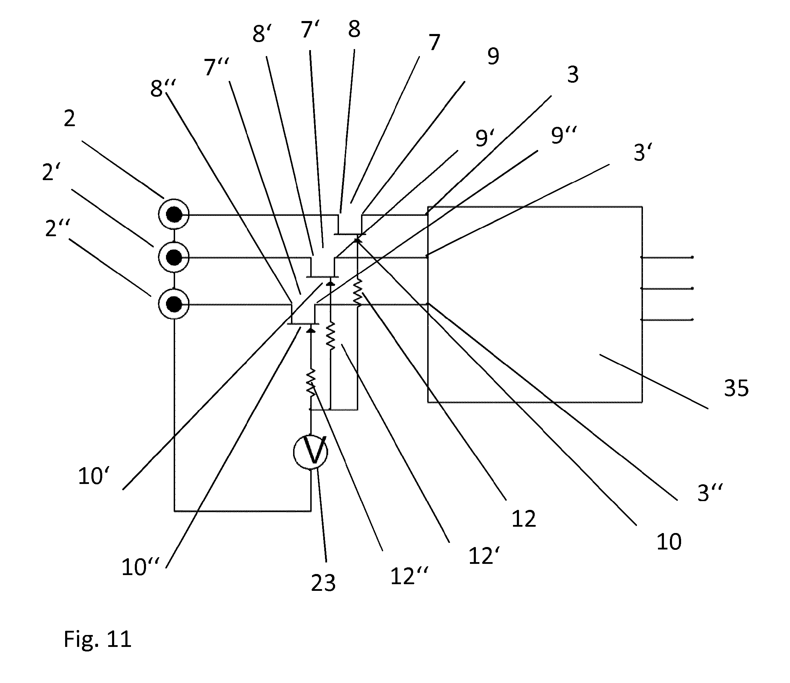

Figur 11 zeigt eine schematische Darstellung eines Anwendungsbeispiels des Spannungsbegrenzers 1, der drei Ausgänge 3, 3', 3" aufweist. Die Ausgänge 3, 3', 3" des Spannungsbegrenzers 1 sind mit einer Steuereinrichtung 35 verbunden. In diesem Ausführungsbeispiel werden auf die Eingänge 2, 2', 2" des Spannungsbegrenzers 1 gegebenen Signale mittels der Haupttransistoren 7, 7', 7" auf einen Maximalwert begrenzt und zur Steuerung eines mit der Steuereinrichtung 35 verbundenen Gerätes verwendet. Beispielsweise kann es sich um eine PWM (Pulsweitenmodulation)-Steuereinheit handeln, über die je eine Ausgangsspannung oder je ein Ausgangsstrom pro Ausgang 3, 3', 3" des Spannungsbegrenzers 1 gesteuert wird. Mit den begrenzten Ausgangssignalen des Spannungsbegrenzers 1 kann in der PWM-Steuereinheit eine Pulsweitenmodulation erfolgen. Hierdurch kann z.B. die Stromversorgung von elektrischen Vorrichtungen, insbesondere von trägen Massen, wie Motoren, gesteuert werden. Diese Anwendung kann z.B. auch mit dem Ausführungsbeispiel des Spannungsbegrenzers 1 mit nur einem Haupttransistor 7 oder mit einer anderen für die jeweilige Anwendung geeigneten Anzahl von parallelgeschalteten Haupttransistoren 7 erfolgen.

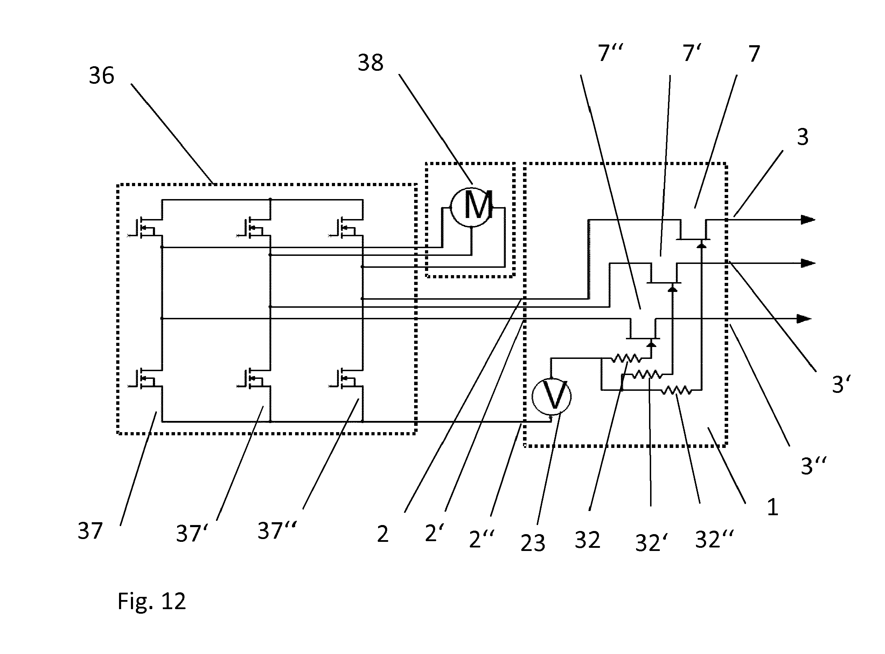

In Figur 12 ist die Verwendung eines Ausführungsbeispiels des Spannungsbegrenzers 1 zur Überwachung eines Motorantriebs schematisch dargestellt. Eine Motortreibereinheit 36 umfasst drei Transistorpaare 37, 37', 37", die jeweils mit den Zuleitungen eines Drei-Phasenmotors 38 verbunden sind. Es ist ein Spannungsbegrenzer 1 mit drei Eingängen 2, 2', 2", drei Ausgängen 3, 3', 3" und drei Haupttransistoren 7, 7', 7" vorgesehen. Die Eingänge 2, 2', 2" des Spannungsbegrenzers 1 sind jeweils mit einem der Transistorpaare 37, 37', 37" der Motortreibereinheit verbunden, wobei jeweils ein Spannungssignal zwischen den Transistorpaaren 37, 37', 37" abgegriffen wird. Mit der Gleichspannungsquelle 23 werden die vorgegebenen Maximalwerte der Haupttransistoren 7, 7', 7" eingestellt. Die auf die Maximalwerte begrenzten Signale der Motortreibereinheit 38 werden von den Ausgängen 3, 3', 3" des Spannungsbegrenzers 1 auf die Steuereinheit (nicht gezeigt) zur Überwachung und zum Schutz der Treibereinheit 36 und des Motors 38 gegeben.

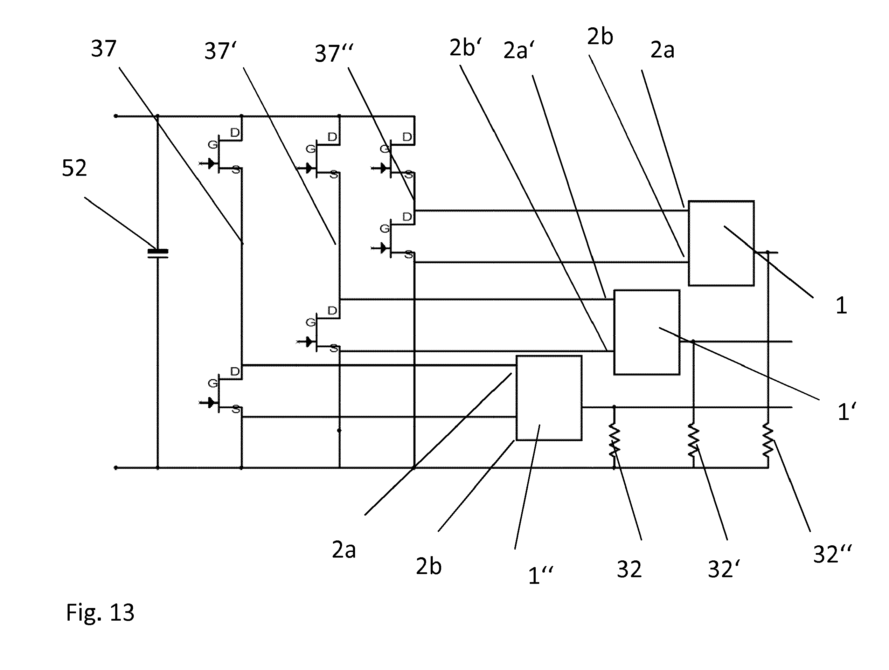

In Figur 13 ist eine ähnliche Verwendung für den Spannungsbegrenzer 1 gezeigt wie in Figur 11. Hier werden drei Spannungsbegrenzer 1, 1', 1" verwendet, die jeweils einen Eingang 2, 2', 2" aufweisen. Auf den jeweiligen Eingang 2, 2', 2" eines jeden Spannungsbegrenzers wird hier jeweils die Source-Drain-Spannung eines Haupttransistors 7, 7',7" eines Transistorpaares 37, 37', 37" gegeben. Die Ausgangsspannung der Spannungsbegrenzer 1, 1', 1" kann jeweils über einem Ausgangswiderstand 32, 32',32" abgegriffen werden. Wegen der hohen Ströme haben die Source-Anschlüsse der Haupttransistoren 7, 7', 7" hier nicht die gleiche Spannung. Daher können sie nicht miteinander verbunden werden; denn es würde ein hoher Strom in den Spannungsbegrenzern 1, 1', 1" fließen. Dadurch könnte das Rauschen an den Source-Anschlüssen größer werden als das Messsignal. Hier ist es vorteilhaft, wenn Spannungsbegrenzer 1, 1', 1" verwendet werden, vor deren Ausgang 3, 3', 3" jeweils eine Stromquelle 31 angeordnet ist, wie dies im Zusammenhang mit dem Ausführungsbeispiel der Figur 9 beschrieben wurde. Es liegt dann die Ausgangsspannung eines jeden der Spannungsbegrenzer 1, 1', 1" an dem jeweiligen Ausgangswiderstand 32, 32', 32" der Spannungsbegrenzer 1, 1', 1" an. Dann können die Spannungen der einzelnen Haupttransistoren 7, 7',7" unabhängig voneinander gemessen werden. Hierdurch sind die Bezugspotentiale des Eingangs und des Ausgangs eines jeden Spannungsbegrenzers lokal voneinander getrennt. Das Rauschen und eine Offset-Spannung in den Source-Verbindungen der Haupttransistoren 7, 7',7" kann so aus dem Ausgangssignal eliminiert werden. Die gemessenen Spannungen können danach an einem gemeinsamen Punkt wieder zusammengeführt werden. Zum Verhindern von Hochfrequenzstörungen ist ein Kondensator 52 vorgesehen.

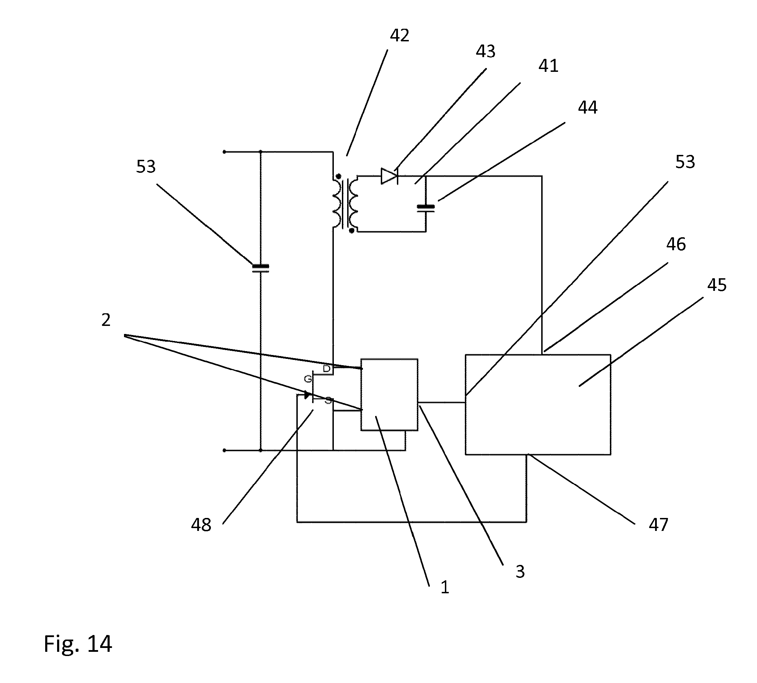

Figur 14 zeigt die Verwendung des erfindungsgemäßen Spannungsbegrenzers 1 zum Regeln eines Schaltnetzteiles 41. Das gezeigte beispielhafte Schaltnetzteil umfasst einen Transformator 42, ein Gleichrichterelement 43 und einen Glättungskondensator 44. Zur Spannungsversorgung ist eine Spannungsquelle 53 vorgesehen. Ferner ist eine PWM (Pulsweitenmodulation)-Steuereinheit 45 vorgesehen, deren erster Eingang 46 mit den Schaltnetzteil 41 verbunden ist, deren zweiter Eingang 53 mit dem Spannungsbegrenzers 1 und deren Ausgang 47 mit dem Gate-Anschluss eines Leistungstransistors 48 verbunden ist. Der Source- und der Drain-Anschluss des Leistungstransistors 48 ist jeweils mit dem Eingang 2 des Spannungsbegrenzers 1 verbunden. Der Drain-Anschluss des Leistungstransistors 48 ist mit einer Primärwicklung des Transformators 42 verbunden, der Source-Anschluss mit einem gemeinsamen Potential, mit dem auch der Spannungsbegrenzer 1 verbunden ist. Das Ausgangsspannungssignal des Schaltnetzteils 41 wird in der PWM-Steuereinheit 45 gemessen, mit dem Signal von dem Spannungsbegrenzer 1 moduliert. Das Ausgangsspannungssignal der PWM-Steuereinheit wird so geregelt, dass ein vorgegebener Zielwert erreicht wird. Mit dem Ausgangssignal des Ausgangs 47 wird der Leistungstransistors 48 über seinen Gate-Anschluss so geregelt, so dass eine geregelte Stromversorgung der Primärwicklung des Transformators 42 gewährleistet ist.

Mit dem Spannungsbegrenzer 1 kann die Ausgangsspannung des Regeltransistors 48 zuverlässig gemessen, dargestellt und überwacht werden. Dasselbe gilt für Eigenschaften des Regeltransistors 48, die in Korrelation zu dessen Ausgangsspannung stehen. Insbesondere kann so der Strom des Leistungstransistors 48 überwacht werden. Hierzu wird im Stand der Technik ein Strommesswiderstand oder ein Stromtransformator verwendet werden. Diese sind damit nicht mehr erforderlich.

Es wird ausdrücklich darauf hingewiesen, dass die Figuren und die Beschreibung spezifische und beispielhafte Ausführungsbeispiele der Erfindung sind, die keinen einschränkenden Charakter haben. Weiter Ausführungsbeispiele und Kombinationen fallen ebenfalls in den Schutzbereich der Erfindung.

### Bezugszeichenliste

- 1: Spannungsbegrenzer
- 2, 2a, 2b: Eingang
- 3: Ausgang
- 4: Schalter
- 5: Schalttransistor
- 6: Messgerät
- 7: Haupttransistor
- 8: Drain-Anschluss
- 9: Source-Anschluss
- 10, 10', 10": Gate-Anschluss
- 11: Nebentransistor
- 12, 12': Schutzwiderstand
- 13. 13': Kondensatorelement
- 14: Überspannungsschutzelement
- 15: Transistorpaar
- 16, 16': Source-Anschluss des Transistorpaares
- 17, 17': Drain-Anschluss des Transistorpaares
- 18: Gate-Anschlüsse des Transistorpaares
- 19: Spannungsbegrenzendes Element
- 20: Messtransistor
- 21: Niederspannungs-Transistor
- 22: Gemeinsames Bezugspotential
- 23: Gleichspannungsquelle
- 24: Zusatztransistor
- 25: Drain
- 26: Source
- 27: Gate
- 28: zweiter Schutzwiderstand
- 29: Widerstandselement
- 30: kapazitives Element
- 31: Stromquelle
- 32: Ausganswiderstand
- 33: Ausgangswiderstand
- 35: Steuereinrichtung
- 36: Motor
- 37: Transistorpaar
- 38: Motor
- 40: Leistungstransistor
- 41: Schaltnetzteil
- 42: Transformator
- 43: Gleichrichterelement
- 44: Glättungskondensator
- 45: PWM-Steuereinheit
- 46: erster Eingang der PWM
- 47: Ausgang der PWM
- 48: Leistungstransistor
- 49: Drain-Anschluss des Leistungstransistors
- 50: Source-Anschluss des Leistungstransistors
- 51: Gate-Anschluss des Leistungstransistors
- 52: Kondensator
- 53: Spannungsquelle

## Patentansprüche

1. Spannungsbegrenzer für Leistungsbauelemente mit einem unipolaren Haupttransistor (7), wobei der Haupttransistor (7) einen Drain-Anschluss (8) aufweist, der mit einem Eingang (2) des Spannungsbegrenzers (1) verbunden ist, einen Source-Anschluss (9), der mit einem Ausgang (3) des Spannungsbegrenzers (1) verbunden ist, und einen Gate-Anschluss (10), **dadurch gekennzeichnet, dass** der Gate-Anschluss (10) des Haupttransistors (7) mit einem vorherbestimmten Potential verbunden ist, das so gewählt ist, dass ein am Drain-Anschluss (8) anliegendes Eingangsspannungssignal am Source-Anschluss (9) auf einen vorgegebenen Maximalwert begrenzt wird.

2. Spannungsbegrenzer nach Anspruch 1, **dadurch gekennzeichnet, dass** das vorherbestimmte Potential zumindest periodisch konstant ist.

3. Spannungsbegrenzer nach Anspruch 1, **dadurch gekennzeichnet, dass** als Haupttransistor (7) ein selbstleitender Transistor vorgesehen ist, dessen Gate-Anschluss (10) mit einem gemeinsamen Bezugspotential (22) verbunden ist.

4. Spannungsbegrenzer nach einem der vorangehenden Ansprüche, **dadurch gekennzeichnet, dass** zwischen dem Gate-Anschluss (10) des Haupttransistors (7) und dem vorherbestimmten Potential ein erster Schutzwiderstand (12) vorgesehen ist und ein Kondensator-Element (13) parallel zu dem ersten Schutzwiderstand (12) angeordnet ist.

5. Spannungsbegrenzer nach einem der vorangehenden Ansprüche, **dadurch gekennzeichnet, dass** ein Überspannungsschutzelement (14) zwischen den Source-Anschluss (9) des Haupttransistors (7) und das gemeinsame Bezugspotential geschaltet ist.

6. Spannungsbegrenzer nach einem der vorangehenden Ansprüche, **dadurch gekennzeichnet, dass** ein unipolarer Nebentransistor (11) in Reihe zu dem Haupttransistor (7) angeordnet ist.

7. Spannungsbegrenzer nach einem der vorangehenden Ansprüche, **dadurch gekennzeichnet, dass** ein "matched-pair" Transistorpaar (15) vom gleiche Leitungstyp wie der Haupttransistor zwischen dem Haupttransistor (7) und dem Ausgang (3) angeordnet ist.

8. Spannungsbegrenzer nach einem der vorangehenden Ansprüche, **dadurch gekennzeichnet, dass** ein Leistungstransistor (40), vorgesehen ist, dessen Drain-Anschluss (49) mit dem Eingang (2) des Spannungsbegrenzers (1) verbunden ist, dessen Source-Anschluss (50) mit einem gemeinsamem Bezugspotential (22) verbunden ist und dessen Gate-Anschluss (51) mit einem zumindest periodisch konstanten Potential verbunden ist.

9. Spannungsbegrenzer nach Anspruch 8, **dadurch gekennzeichnet, dass** der Gate-Anschluss (51) des Leistungstransistors (40) mit dem Gate-Anschluss (10) des Haupttransistors (7) verbunden ist.

10. Spannungsbegrenzer nach Anspruch 8 oder 9, **dadurch gekennzeichnet, dass** der Haupttransistor (7) als ein Zell-Transistor des Leistungstransistors (40) ausgebildet ist.

11. Spannungsbegrenzer nach einem der vorangehenden Ansprüche, **dadurch gekennzeichnet, dass** das Bezugspotential des Ausgangs (3) des Spannungsbegrenzers (1) von dem Bezugspotential des Eingangs (2) des Spannungsbegrenzers (1) getrennt ist.

12. Spannungsbegrenzer nach einem der vorangehenden Ansprüche, **dadurch gekennzeichnet, dass** der Source-Anschluss (9) des Haupttransistors (7) mit einer Stromquelle (31) verbunden ist, deren Strom proportional zu der Spannung zwischen dem Source-Anschluss (9) des Haupttransistors (7) und dem gemeinsamen Bezugspotential ist, und welche in Reihe mit einem Ausgangswiderstand (32, 33) geschaltet ist, und die Ausgangsspannung des Spannungsverstärkers an wenigstens einem Teil des Ausgangswiderstands (33) abgreifbar ist.

13. Spannungsbegrenzer nach einem der vorangehenden Ansprüche, **dadurch gekennzeichnet, dass** mindestens ein zweiter Haupttransistor (7') vorgesehen ist, welcher einen Drain-Anschluss (8') aufweist, der mit einem zweiten Eingang (2') des Spannungsbegrenzers (1) verbunden ist, einen Source-Anschluss (9'), der mit einem zweiten Ausgang (3') des Spannungsbegrenzers (1) verbunden ist, und einen Gate-Anschluss (10'), der mit dem gleichen Potential wie der Gate-Anschluss (10) des ersten Haupttransistors (7) verbunden ist.

14. Verwendung des Spannungsbegrenzers nach einem der Ansprüche 1 bis 13 zum Bestimmen von Werten, die in Korrelation stehen mit Spannungswerten im Niederspannungsbereich eines Leistungshalbleiterelements, wobei ein Spannungssignal des Leistungshalbleiterelements dem Eingang (2) des Spannungsbegrenzers (1) als Eingangssignal zugeführt wird, das auf den vorgegebenen Maximalwert begrenzte Signal am Ausgang (3) des Spannungsbegrenzers (1) als Ausgangsspannungssignal abgegriffen und derart verarbeitet wird, dass in Korrelation mit den abgegriffenen Spannungswerten stehende Werte bestimmt und/oder dargestellt werden.

15. Verwendung des Spannungsbegrenzers Anspruch 14, **dadurch gekennzeichnet, dass** das am Ausgang (3) des Spannungsbegrenzers (1) abgegriffene Spannungssignal zum Regeln einer Energieversorgungseinheit einer elektrischen Vorrichtung, insbesondere eines Motors (38) oder eines Schaltnetzteils, verwendet wird.

16. Verwendung des Spannungsbegrenzers nach Anspruch 14, **dadurch gekennzeichnet, dass** das am Ausgang (3) des Spannungsbegrenzers (1) abgegriffene Spannungssignal zum Schutz einer elektrischen Vorrichtung, insbesondere eines Motors (38) oder eines Schaltnetzteils, vor Überstrom, oder einer Überlast verwendet wird.

17. Verwendung des Spannungsbegrenzers nach Anspruch 14, **dadurch gekennzeichnet, dass** das am Ausgang (3) des Spannungsbegrenzers (1) abgegriffene Spannungssignal zum Überwachen des Betriebs eines Leistungstransistors verwendet wird.
